# EUROPEAN PATENT APPLICATION

(11) **EP 4 523 925 A1**
(43) Date of publication of application: **19.03.2025**
(21) Application number: 23802639.7
(22) Date of filing: 24.04.2023
(51) Int. Cl.: B44C 5/04, H05K 5/02

(54) **DECORATIVE SUBSTRATE AND MANUFACTURING METHOD THEREFOR, COVER PLATE AND ELECTRONIC DEVICE**

(30) Priority: 10.05.2022 CN 202210507502
(71) Applicant: BYD Company Limited, Shenzhen, Guangdong 518118 (CN)
(72) Inventor: ZHAO, Lihong, Shenzhen, Guangdong 518118 (CN); LUO, Wenhai, Shenzhen, Guangdong 518118 (CN); ZHU, Qiyu, Shenzhen, Guangdong 518118 (CN)
(74) Representative: Mathys & Squire
(86) International application number: PCT/CN2023/090308
(87) International publication number: WO 2023/216865

(57) **Abstract**

Provided are a decorative substrate and a manufacturing method therefor, a cover plate, and an electronic device. The decorative substrate comprises a base material and a texture layer arranged on the surface of the base material. The texture layer is provided with multiple texture units which are sequentially arranged in a first direction. Each texture unit comprises a protruding part. The cross section of the protruding part in a third direction transitions from an arc segment to a straight line segment in a second direction, wherein the second direction is perpendicular to the first direction, and the third direction is perpendicular to the first direction and the second direction. The highest points of the cross section of the protruding part in the third direction meet at least one of the following relationships: the distance between the highest points of the cross section of the protruding part in the third direction and the surface of the base material changes in the second direction; or the connecting line between the orthographic projections of the highest points of the cross section of the protruding part in the third direction on the base material is an arc segment or a straight line segment, the straight line segment being not parallel to the second direction.

## Description

### CROSS-REFERENCE TO RELATED APPLICATIONS

The present application claims priority to Chinese Patent Application No. 202210507502.8 filed on May 10, 2022, the application title of which is "Decorative substrate and preparation method and application thereof", which is incorporated herein by reference in its entirety.

### FIELD

The present disclosure relates to the field of decoration technology, and specifically to a decorative substrate and a manufacturing method therefor, a cover plate and an electronic device.

### BACKGROUND

As a new type of decorative material, gradient decorative films are widely used in electronic device and other fields. However, existing gradient decorative films are mainly achieved color changes through coating methods. The color changes of gradient colors are limited by the structure of the coating. The gradient is relatively fixed and single, and the gradient decorative film has the same gradient color when viewed from different angles. The color change is not three-dimensional enough and cannot meet the needs of consumers.

### CONTENTS OF THE INVENTION

In order to solve the above problems, the present application provides a decorative substrate, which has different color gradients when viewed from different viewing angles, thereby presenting a good decorative effect.

A first aspect of the present application provides a decorative substrate. The decorative substrate includes a base material and a texture layer disposed on the surface of the base material. Each of the texture units includes a convex portion, and a cross-sectional outline of the convex portion in a third direction transitions from arc segments to straight line segments along the second direction, the second direction is perpendicular to the first direction, and the third direction is perpendicular to the first direction and the second direction;

The highest point of the cross-sectional outline of the convex portion in a third direction satisfies at least one of the following relationships: the distance from the highest point of the cross-sectional outline of the convex portion in a third direction to the base material surface changes in the second direction; or the line connecting the orthographic projection of the highest point of the cross-sectional outline of the convex portion in the third direction on the base material is a curve segment or a straight line segment, and the straight line segment is not parallel to the second direction.

The texture unit of this application has a multi-level changing structure. The texture unit has changes in height and width at different angles, allowing light to reflect, scatter, refract, etc. in different microstructures, thereby reflecting light of different intensities, showing changes in light and dark, and scattering different colors, showing a gradient effect. The decorative substrate of this structure can show dynamic color changes under different viewing angles, that is, it has a real-time changing gradient effect, which greatly improves the decorative effect.

In some embodiments, the distance from the highest point of the cross-sectional outline of the convex portion in a third direction to the base material surface does not change in the second direction; the line connecting the orthographic projection of the highest point of the cross-sectional outline of the convex portion in the third direction on the base material is a curve segment or a straight line segment, and the straight line segment is not parallel to the second direction.

In some embodiments, the distance from the highest point of the cross-sectional outline of the convex portion in a third direction to the base material surface changes in the second direction; the line connecting the orthographic projection of the highest point of the cross-sectional outline of the convex portion in the third direction on the base material is a curve segment or a straight line segment, and the straight line segment is parallel to the second direction.

In some embodiments, the distance from the highest point of the cross-sectional outline of the convex portion in a third direction to the base material surface changes in the second direction; the line connecting the orthographic projection of the highest point of the cross-sectional outline of the convex portion in the third direction on the base material is a curve segment or a straight line segment, and the straight line segment is not parallel to the second direction.

In some embodiments, the first direction includes a circumferential direction or a linear direction.

In some embodiments, the convex portion includes a linear segment and a nonlinear segment in the second direction, and the outer contour of the orthographic projection on the base material of the linear segment is a straight line, and the outer contour of the orthographic projection of the nonlinear segment on the base material is an arc shape.

In some embodiments, the outer contour of the orthographic projection of the nonlinear segment on the base material is wavy.

In some embodiments, the nonlinear segment includes a wide portion and a narrow portion; the maximum width of any of the wide portions is greater than the maximum width of the linear segment, or the minimum width of any of the narrow portions is less than the minimum width of the linear portion.

In some embodiments, the distance from the highest point of the cross-sectional outline of the convex portion in a third direction to the base material surface changes linearly in the second direction.

In some embodiments, the distance from the highest point of the cross-sectional outline of the convex portion in a third direction to the base material surface changes non-linearly in the second direction.

In some embodiments, the distance between adjacent convex portions ranges from 1 µm to 200 µm.

In some embodiments, the width of the convex portion in the first direction ranges from 1 µm to 200 µm.

In some embodiments, the height difference between the highest point of the cross-sectional outline of the convex portion and the lowest point of the cross-sectional outline of the convex portion in the first direction is 0.5 µm to 20 µm.

In some embodiments, the decorative substrate further includes a modification layer, the modification layer includes at least one of a color layer, a frosted layer, and a glitter layer, and the modification layer is disposed on surface of at least one of the texture layer or the base material.

A second aspect of this application provides a method for manufacturing a decorative substrate, which method includes:
A texture layer is formed on the surface of the base material to obtain the decorative substrate; the texture layer is formed by at least one of transfer, etching and hot press molding; the texture layer has a plurality of texture units arranged sequentially along first direction. each of the texture units includes a convex portion, the cross-sectional outline of the convex portion in the third direction transitions from an arc segment to a straight line segment along the second direction, and the second direction is perpendicular to the a first direction, the third direction is perpendicular to the first direction and the second direction;

The highest point of the cross-sectional outline of the convex portion in a third direction satisfies at least one of the following relationships: the distance from the highest point of the cross-sectional outline of the convex portion in a third direction to the base material surface changes in the second direction; or the line connecting the orthographic projection of the highest point of the cross-sectional outline of the convex portion in the third direction on the base material is a curve segment or a straight line segment, and the straight line segment is not parallel to the second direction.

The manufacturing method provided by this application is simple and easy to operate, the process is mature, and it is convenient for industrial production.

A third aspect of the present application provides a cover plate, which includes the decorative substrate as described in the first aspect and a base body, where the decorative substrate is disposed on the surface of the base body.

A fourth aspect of the present application provides an electronic device, which includes a display component and a housing that cooperates with the display component, wherein the housing includes the cover plate as described in the third aspect.

### BRIEF DESCRIPTION OF THE DRAWINGS

Figure 1 is a front view of a decorative substrate provided by an embodiment of the present application;
Figure 2 is a top view of the texture layer provided by an embodiment of the present application;
Figure 3 is a top view of the texture layer provided by an embodiment of the present application;
Figure 4 is a schematic structural diagram of a texture unit provided by an embodiment of the present application;
Figure 5 is a schematic diagram of a cross-sectional outline provided by an embodiment of the present application;
Figure 6 is a schematic structural diagram of a texture unit provided by an embodiment of the present application;
Figure 7 is a schematic structural diagram of a texture unit provided by an embodiment of the present application;
Figure 8 is a top view of a texture unit provided by an embodiment of the present application;
Figure 9 is a schematic structural diagram of a nonlinear segment provided by an embodiment of the present application;
Figure 10 is a variation curve of the width of the convex portion in the second direction provided by an embodiment of the present application;
Figure 11 is a variation curve of the width of the convex portion in the second direction provided by an embodiment of the present application;
Figure 12 is a front view of the texture layer provided by an embodiment of the present application;
Figure 13 is a front view of the texture layer provided by an embodiment of the present application;
Figure 14 is a schematic structural diagram of an electronic device provided by an embodiment of the present application;
Figure 15 is a top view of the decorative substrate provided in Embodiment 1 of the present application;
Figure 16 is a schematic diagram of the effect of the decorative substrate provided in Embodiment 1 of the present application;
Figure 17 is a top view of the decorative substrate provided in Embodiment 2 of the present application;
Figure 18 is a schematic diagram of the effect of the decorative substrate provided in Embodiment 2 of the present application;
Figure 19 is a top view of the decorative substrate provided in Embodiment 2 of the present application;
Figure 20 is another structural schematic diagram of the decorative substrate provided in Embodiment 2 of the present application;
Figure 21 is a schematic diagram of the effect of the decorative substrate provided in Embodiment 3 of the present application;
Figure 22 is a front view of a decorative substrate provided by an embodiment of the present application.

### DETAILED DESCRIPTION

The technical solutions in the embodiments of the present application will be described clearly and completely below with reference to the drawings in the embodiments of the present application. Obviously, the described embodiments are only some of the embodiments of the present application, rather than all of the embodiments. Based on the embodiments in this application, all other embodiments obtained by those of ordinary skill in the art without creative efforts fall within the scope of protection of this application.

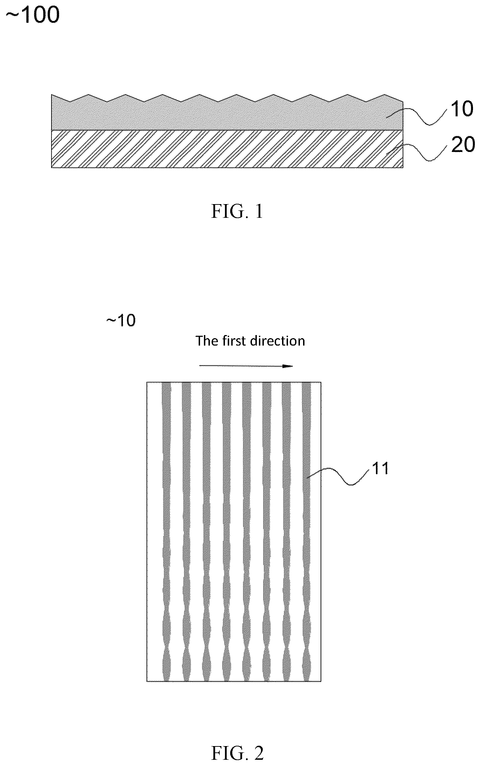

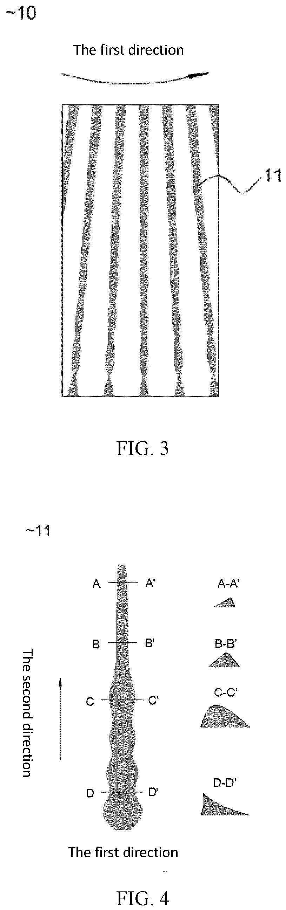

Please refer to Figure 1. Figure 1 is a front view of a decorative substrate provided by an embodiment of the present application. The decorative substrate 100 includes a base material 20 and a texture layer 10 disposed on the surface of the base material 20. The material of the base material includes at least one of plastic, metal, ceramics and glass. Please refer to FIG. 2 . FIG. 2 is a top view of a texture layer provided by an embodiment of the present application. The texture layer 10 has a plurality of texture units 11 arranged sequentially along a first direction, where the first direction is a linear direction. In some embodiments of the present application, the first direction is the circumferential direction. Please refer to Figure 3. Figure 3 is a top view of the texture layer provided by an embodiment of the present application. The texture layer 10 has a plurality of texture units 11 arranged sequentially along the first direction, where the first direction is the circumferential direction. In the embodiment of the present application, multiple texture units may have the same or different structures (shapes).

In this application, the first direction and the second direction are perpendicular to each other, and the third direction is perpendicular to the plane where the first direction and the second direction are located. In the embodiment of the present application, the texture unit includes a convex portion, and the outer surface of the convex portion transitions from a saddle shape to a prism shape in the second direction. It can be understood that multiple cross-sectional outlines are obtained by cutting a single convex portion at different positions with the plane where the first and third directions are located, and the multiple cross-sectional outlines transition from arc segments to straight line segments in the second direction. Please refer to Figure 4. Figure 4 is a schematic structural diagram of a texture unit provided by an embodiment of the present application. The outer surface of the convex portion (dark area in the figure) of the texture unit 11 transitions from a saddle shape to a prism shape in the second direction. Cut the texture unit with the plane where the first direction and the third direction (direction perpendicular to the paper surface) are located, and obtain the cross-section of the convex portion at different positions. The intersection line between the outer surface of the convex portion and the plane (where the first and third directions are located) is the cross-sectional outline, and the cross-sectional outlines in the second direction are D-D', C-C', B-B', and A-A', where D-D', C-C' and B-B' are composed of arc segments, and A-A' is composed of straight line segments. In the embodiment of the present application, the arc segment includes an upward convex arc segment and a downward convex arc segment.

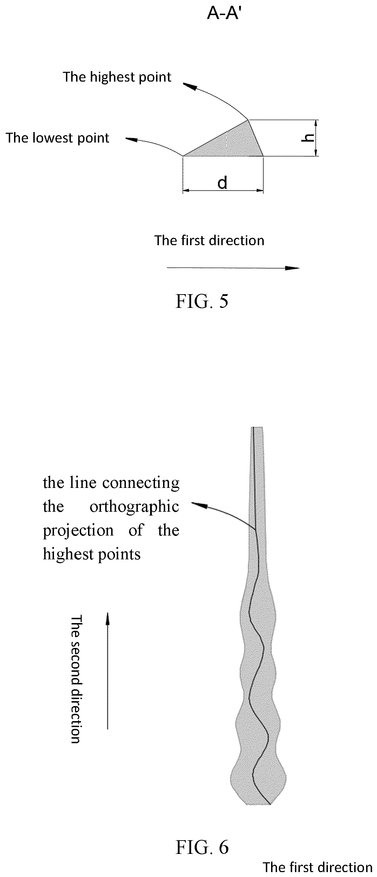

In order to express the solution of this application clearly, some terms in this application are explained as follows: The width of the convex portion in this application refers to the width of the convex portion in the first direction. Specifically, the width of the convex portion can be obtained by cutting the texture unit with the plane where the first direction and the third direction are located, and the length of the bottom side of the cross-sectional outline is the width of the convex portion. Please refer to Figure 5. Figure 5 is a schematic diagram of a cross-sectional outline provided by an embodiment of the present application. In Figure 5, the length of the bottom side of the cross-sectional outline is the width d of the convex portion. The distance from the highest point of the convex portion in the third direction to the surface of the base material refers to the height difference between the highest point of the cross-sectional outline and the lowest point of the cross-sectional outline. Please refer to Figure 5. The distance h from the highest point of the cross-sectional outline A-A' to the surface of the base material is the height difference between the highest point of the cross-sectional outline and the lowest point of the cross-sectional outline (at the edge of the cross-sectional outline). In this application, the vertex trend line of the convex portion refers to the line connecting the orthographic projection of the highest point of the cross-sectional outline of the convex portions on the base material in the third direction. This connecting line can be a curve segment or a straight line segment. The vertex trend line of the convex portion can be understood as cutting the texture unit with the plane where the first direction and the third direction are located to obtain several cross-sectional outline, projecting the highest points of the several cross-sectional outlines on the surface of the base material to obtain several points, and connecting several points to get the target curve. By setting the position and shape of the above-mentioned connecting lines, you can adjust the vertex trend of the convex portion, so that the decorative substrate presents a rhythmic pattern effect. Please refer to FIG. 6, FIG. 6 is a schematic structural diagram of a texture unit provided by an embodiment of the present application, in which the line connecting the orthographic projection of the highest point of the cross-sectional outline of the convex portions on the base material in the third direction is a curve segment.

In this application, the position of the vertex of the texture unit of the convex portion changes in the second direction, and the change can be a change in the height of the vertex, or a change in the position of the vertex in the first direction, where the change in the height of the vertex refers to the change in the distance h from the highest point of the cross-sectional outline of the convex portion in the third direction to the base material surface in the second direction; the change in the position of the vertex in the first direction is also the change in the vertex trend line. This change can be understood that: the line connecting the orthographic projection of the highest point of the cross-sectional outline of a single convex portion in the third direction on the base material is a curve segment or a straight segment, and the straight segment is not parallel to the second direction. This application can realize multi-level changes of texture units at different angles by combining the changes in the vertex position of the convex portion with the structural changes on the outer surface of the convex portion. The directional arrangement of the texture units makes the color gradient more natural, thereby achieving decorative substrate with three-dimensional gradient effect.

In some embodiments of the present application, the distance from the highest point of the cross-sectional outline of convex portion in the third direction to the surface of the base material changes in the second direction. In some embodiments of the present application, the distance from the highest point of the cross-sectional outline of convex portion in the third direction to the surface of the base material changes linearly in the second direction, and when the distance from the highest point of the cross-sectional outline of convex portion in the third direction to the surface of the base material changes linearly in the second direction, the color transition of the decorative substrate is more natural. In some embodiments of the present application, the distance from the highest point of the cross-sectional outline of convex portion in the third direction to the surface of the base material changes nonlinearly in the second direction, and when the distance from the highest point of the cross-sectional outline of convex portion in the third direction to the surface of the base material changes nonlinearly in the second direction, the color of the decorative substrate will fluctuate as the height of the convex portion fluctuates, making the dynamic effect more significant.

In some embodiments of the present application, the line connecting the orthographic projection of the highest point of the cross-sectional outline of convex portion in the third direction on the base material is a straight line segment, and the straight line segment is not parallel to the second direction. In some embodiments of the present application, the line connecting the orthographic projection of the highest point of the cross-sectional outline of convex portion in the third direction on the base material is a curve segment. Please refer to Figure 6. In Figure 6, the line connecting the orthographic projection of the highest point of the cross-sectional outline of convex portion in the third direction on the base material is a curve segment. When the line connecting the orthographic projection of the highest point of the cross-sectional outline of convex portion in the third direction on the base material is not parallel to the second direction, it can be combined with the structural change of the outer surface of the convex portion to realize the texture unit in different multi-level changes in angles. And directional arrangement of texture units make the color gradient more natural, thereby achieving a three-dimensional gradient effect on the decorative substrate. Decorative substrates can exhibit more dramatic color variations.

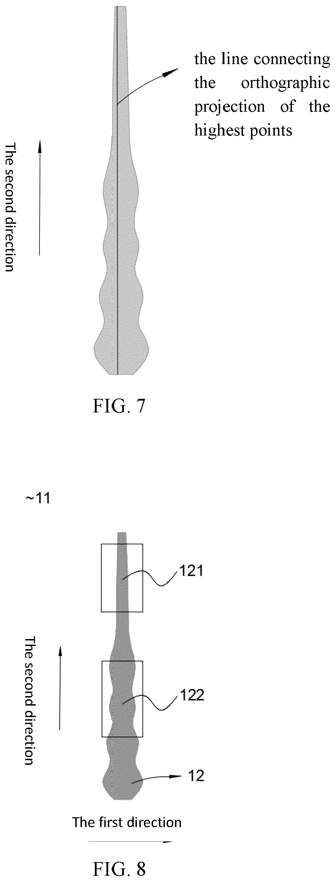

In some embodiments of the present application, the line connecting the orthographic projection of the highest point of the cross-sectional outline of convex portion in the third direction on the base material is a straight line segment, the straight line segment is parallel to the second direction. The distance from the highest point of the cross-sectional outline of convex portion to the surface of the base material changes in the second direction. Please refer to Figure 7. Figure 7 is a schematic structural diagram of a texture unit provided by an embodiment of the present application, in which the line connecting the orthographic projection of the highest point of the cross-sectional outline of convex portion in the third direction on the base material is a straight line segment. The straight line segment is parallel to the second direction. When the line connecting the orthographic projection of the highest point of the cross-sectional outline of convex portion in the third direction on the base material is parallel to the second direction, the color gradient presented by the decorative substrate is relatively regular and has a certain level of beauty.

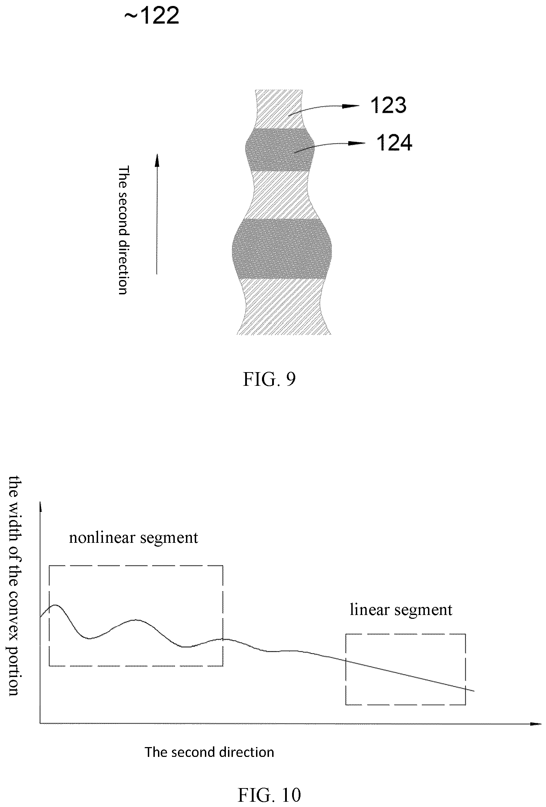

In some embodiments of the present application, the convex portion includes a linear segment and a nonlinear segment in the second direction. The outer contour of the orthographic projection of the linear segment on the base material is linear, and the outer contour of the orthographic projection of the nonlinear segment on the base material is arc-shaped. In some embodiments, the outer contour of the orthographic projection of the nonlinear segment on the base material is wavy. Please refer to Figure 8. Figure 8 is a top view of a texture unit provided by an embodiment of the present application. The convex portion 12 of the texture unit 11 includes a linear segment 121 and a non-linear segment 122 in the second direction. The outer contour of the orthographic projection of the linear segment 121 on the base material is a straight line, and the side edges of the outer contour are straight lines. The outer contour of the orthographic projection of the nonlinear segment 122 on the base material is wavy, and the side edges of the outer contour are wavy lines. The structure can also be understood is: the change curve of the width of the convex portion in the second direction changes from wavy to linear. Since the texture units are directionally arranged in the first direction, adjusting the width of the convex portion in the second direction in the texture unit can make color gradients more diverse and colors richer. In the embodiment of the present application, the nonlinear segment is composed of wide portions and narrow portions alternately arranged in the second direction. Please refer to Figure 9. Figure 9 is a schematic structural diagram of a nonlinear segment provided by an embodiment of the present application. The nonlinear segment 122 includes alternately arranged narrow portions 123 and wide portions 124, and the intersection point of the adjacent wide portions and narrow portions on the outer contour is the point where the slope of the outer contour curve is maximum.

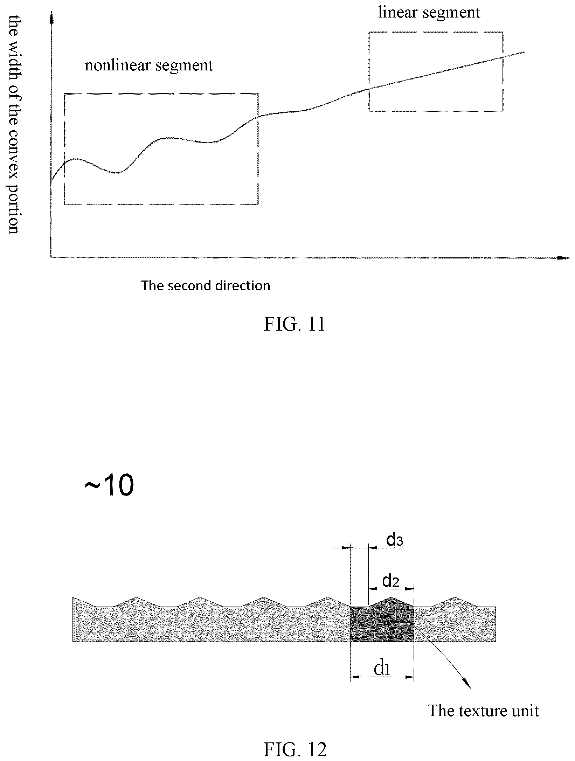

In some embodiments of the present application, the maximum width of any wide portion in the nonlinear segment is greater than the maximum width of the linear segment. Please refer to Figure 10. Figure 10 shows a variation curve of the width of the convex portion in the second direction provided by an embodiment of the present application. This width change curve shows a change from wavy to linear. The wavy area corresponds to the nonlinear segment of the convex portion, and the linear area corresponds to the linear segment of the convex portion. The width of any wave peak in the wave shape is greater than the maximum width of the linear segment, that is, the width of the convex portion shows an overall decreasing trend in the second direction. In some embodiments of the present application, the minimum width of any narrow portion in the nonlinear segment is smaller than the minimum width of the linear segment. Please refer to Figure 11. Figure 11 shows a variation curve from the nonlinear segment to the linear segmen tof the width of the convex portion in the second direction provided by an embodiment of the present application, the width variation curve shows a change from wavy to linear. The wavy area corresponds to the nonlinear segment of the convex portion, and the linear area corresponds to the linear segment of the convex. The width of any wave trough in the wave shape is less than the minimum width of the linear segment, that is, the width of the convex portion shows an overall increasing trend in the direction from the nonlinear segment to the linear segment. This width variation can increase the contrast of colors in different areas of the decorative substrate, thus enhancing the visual impact.

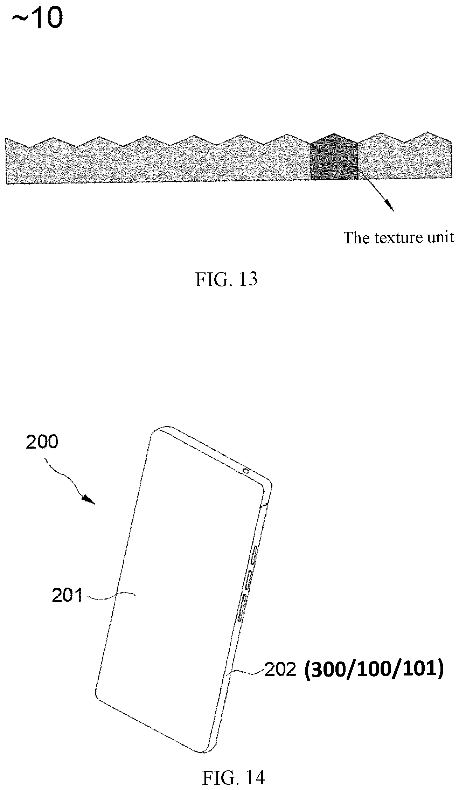

In some embodiments of the present application, the texture unit includes a planar portion and a convex portion arranged sequentially along the first direction. Please refer to Figure 2. In Figure 2, the white area is the planar portion, the dark area is the convex portion, and the planar portion can adjust the gradient effect to make the pattern changes more diverse. Please refer to Figure 12. Figure 12 is a front view of the texture layer provided by an embodiment of the present application. In Figure 12, the dark area is a texture unit. The texture unit includes a planar portion and a convex portion. The width d1 of the texture unit is equal to the sum of the width d2 of the convex portion and the width d3 of the planar portion. Please refer to Figure 13. Figure 13 is a front view of the texture layer provided by an embodiment of the present application. In Figure 13, the texture unit only contains convex portions, that is, it does not have a planar portion. The width of the texture unit is equal to the width of the convex portion. In some embodiments of the present application, the width of the convex portion is 1 µm to 200 µm. The width of the convex portion may be, but is not limited to, 1 µm, 10 µm, 20 µm, 30 µm, 50 µm, 80 µm, 100 µm, 150 µm or 200 µm. In this application, the distance between adjacent convex portions is the width of the planar portion. In some embodiments of the present application, the distance between adjacent convex portions is 1 µm to 200 µm. The distance between adjacent convex portions may be, but is not limited to, 1 µm, 10 µm, 20 µm, 30 µm, 50 µm, 80 µm, 100 µm, 150µm or 200µm. In some embodiments of the present application, the height difference between the highest point and the lowest point of the cross-sectional outline of convex portion in the third direction is 0.5 µm to 20 µm, and the height difference between the highest point and the lowest point of the cross-sectional outline of convex portion in the third direction may specifically be, but is not limited to, 0.5 µm, 1 µm, 2 µm, 5 µm, 10 µm, 15 µm or 20 µm.

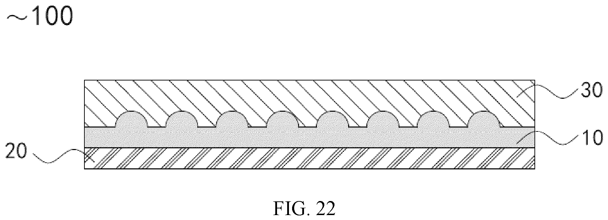

In some embodiments of the present application, the decorative substrate further includes a modification layer 30, and the modification layer includes at least one of a color layer, a frosted layer, and a glitter layer. In the embodiment of the present application, the color layer may be a coating layer or an ink layer, as long as it has a certain color. In this application, the texture layer in the decorative film itself has a certain color effect, and providing a color layer can further enhance the rich color changes. The frosted layer has a certain anti-slip function and has a softer visual effect, which can enrich the appearance of the product. The glitter layer refers to a modification layer that can exhibit a flash point effect. In some embodiments, the glitter layer includes a coating doped with glitter particles. The glitter layer can make the decorative substrate have a certain colorful effect. In some embodiments, the modification layer 30 is disposed on the surface of the texture layer 10 (see Figure 22). In some embodiments, the modification layer 30 is disposed on the surface of the base material 20. In some embodiments, the modification layer 30 is disposed on the surfaces of the base material 20. In some embodiments, the modification layer 30 is disposed on surface of base material 20 and texture layer 10.

In the decorative substrate provided by this application, the texture layer has a continuously changing characteristic structure. This structure can realize the color change of the decorative substrate at different angles. For example, when viewed from the front, it is a gradient from light purple to light yellow, and when viewed from the side, it is a gradient from light purple to light blue, presenting a dynamic three-dimensional color gradient effect, thereby greatly improving the aesthetics of the product.

The present application also provides a method for manufacturing the decorative substrate. In the embodiment of the present application, the method for manufacturing the texture layer includes at least one of etching, UV transfer, and hot press molding. In some embodiments, the base material includes a transparent film. For example, the base material can be a polyester substrate (PET film), a polycarbonate substrate (PC film), or a polymethylmethacrylate substrate (PMMA film). The manufacturing method of the decorative substrate includes: producing a texture master with a texture pattern on a mold according to the pattern of the texture layer, and transferring the texture master to the surface of the base material to obtain a decorative substrate. The obtained decorative substrate is a texture film. In some embodiments, the base material includes a plastic sheet, and the manufacturing method of the decorative substrate includes: transferring a texture master to the surface of the base material, and then hot-pressing and forming the decorative substrate. The resulting decorative substrate is a textured plastic sheet. In some embodiments, the base material includes glass, and the method for manufacturing the decorative substrate includes: preparing a mask on the surface of the base material according to the pattern of the texture layer, and etching the base material. Stronger etching at thinner masks and weaker etching at thicker masks to form a texture pattern on the surface of the base material, and obtain a decorative substrate, which is textured glass. The manufacturing method of the decorative substrate provided by this application has mature technology, simple process, and high stability of the products produced, which can improve the yield rate of the product and is suitable for mass production.

The present application also provides a cover plate 300, which includes the decorative substrate 100 and a base body 101 of the present application (see Figure 14), wherein the base body is used to improve the structural strength of the cover plate, and the material of the base body can be at least one of plastic, metal, ceramics and glass. The cover plate can show a gradient effect of dynamic color changes at different viewing angles, thereby greatly improving the aesthetics and having good market prospects. In some embodiments of the present application, the cover plate can be used for the casing of communication equipment. The cover plate has a unique appearance and can improve the recognition of the product.

This application also provides an electronic device, which includes the above-mentioned cover plate. Please refer to Figure 14. Figure 14 is a schematic structural diagram of an electronic device provided by an embodiment of the present application. The electronic device 200 includes a display component 201 and a housing 202 that cooperates with the display component 201. The housing 202 includes the cover plate 300 of the present application. In the embodiment of the present application, the electronic device may be a mobile phone, a computer, a watch, a USB flash drive, an electronic cigarette, a wearable device, a digital camera, etc.

Embodiments of the present application are further described below by way of specific examples.

### Example 1

A decorative substrate, the manufacturing method of which includes: transmitting the pattern data of the texture layer to a computer, performing photolithographic exposure on a glass plate coated with photoresist, and after developing, drying, and plasma cleaning, performing UV transfer to transfer the texture printed on PC sheet to obtain decorative substrate. The decorative substrate is bonded to the surface of the glass plate through processes such as coating, printing, cutting, and lamination, and a glass cover plate with a texture pattern is obtained.

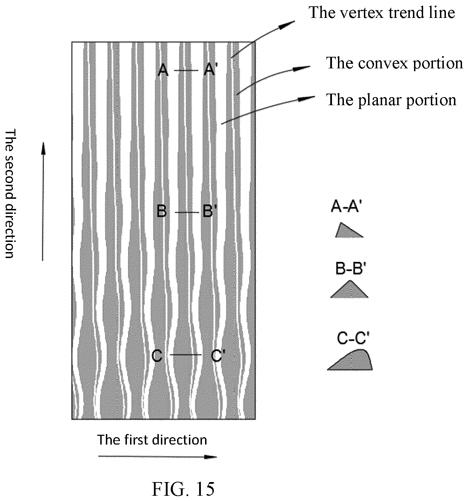

Please refer to Figure 15. Figure 15 is a top view of the decorative substrate provided in Embodiment 1 of the present application. In Figure 15, the texture layer on the surface of the decorative substrate has a plurality of texture units arranged sequentially along a first direction, and the first direction is a linear direction, the texture unit consists of a convex portion (dark area) and a planar portion (white area). The outer contour of the convex portion transitions from wavy to linear; in the second direction, the width of the convex portion shows an overall decreasing trend, while the width of the planar portion shows an overall increasing trend, that is, the interval between the convex portions shows an increasing trend in the second direction; the vertex trend line of the convex portions is not parallel to the second direction, and in the direction from the nonlinear segment to the linear segment, the vertex of the convex portion shows a changing trend from right to left; cut the texture unit with the plane where the first direction and the third direction (the direction perpendicular to the paper surface) are located, and obtain the cross-sections of the convex portions at different positions, A-A', B-B' and C-C', where B-B' and C-C' are composed of arc segments, and A-A' is composed of straight line segments.

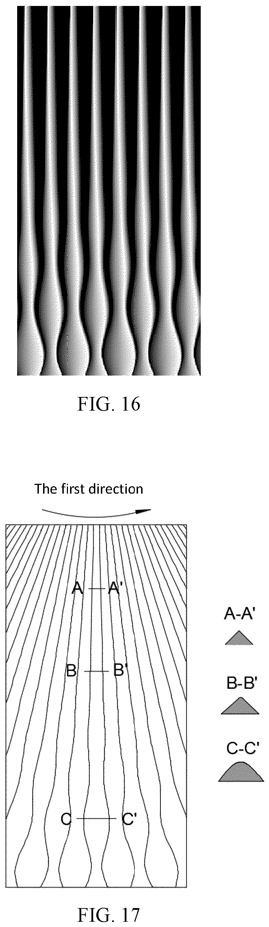

Please refer to Figure 16. Figure 16 is a schematic diagram of the effect of the decorative substrate provided in Embodiment 1 of the present application. It can be seen from Figure 16 that the outer surface of the texture unit has multiple levels of structural changes, thereby making the color gradient richer.

### Example 2

A decorative substrate, the manufacturing method of which includes: transmitting the pattern data of the texture layer to a computer, performing photolithography exposure and development on a glass plate coated with photoresist, forming a texture pattern on the surface of the photoresist, and converting the glass plate with photoresist in a chemical etching tank. Due to the protective effect of the photoresist on the glass, the places where the photoresist is relatively thick resist etching for a long time, while the places where the photoresist is relatively thin resist etching for a short time. Therefore, the thin areas of photoresist leak out the glass layer before the relatively thick areas, forming uneven texture structure and allowing the texture to be completely copied to the glass surface to form a decorative substrate.

Please refer to Figure 17. Figure 17 is a top view of the decorative substrate provided in Embodiment 2 of the present application. In Figure 17, the texture layer on the surface of the decorative substrate has a plurality of texture units arranged sequentially along a first direction, and the first direction is the circumferential direction, the texture unit is composed of a convex portion (without a planar portion), and the outer contour of the convex portion transitions from a wavy to a linear; in the second direction perpendicular to the first direction, the width of the convex portion shows an overall decreasing trend, and the convex portions are left and right symmetrical along the central axis of the texture unit. Cut the texture unit with the plane of the first direction and the third direction (direction perpendicular to the paper surface) to obtain the cross-sections of the convex portion at different positions, A-A', B-B' and C-C', Among them, B-B' and C-C' are composed of arc segments, and A-A' is composed of straight line segments.

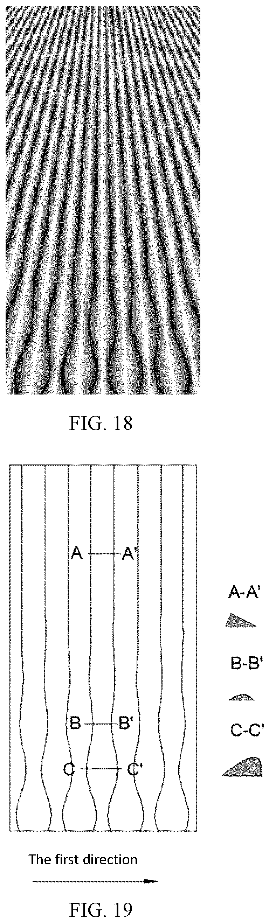

Please refer to FIG. 18, FIG. 18 is a schematic diagram of the effect of the decorative substrate provided in Embodiment 2 of the present application.

### Example 3

A decorative substrate, please refer to Figure 19. Figure 19 is a top view of the decorative substrate provided in Embodiment 3 of the present application. In Figure 19, the texture layer on the surface of the decorative substrate has a plurality of texture units arranged sequentially along the first direction. The first direction is a linear direction, the texture unit is composed of a convex portion (without a planar portion), and the outer contour of the convex portion transitions from a wavy to a linear; Cut the texture unit with the plane of the first direction and the third direction (direction perpendicular to the paper surface) to obtain the cross-sections of the convex portion at different positions, A-A', B-B' and C-C', Among them, B-B' and C-C' are composed of arc segments, and A-A' is composed of straight line segments.

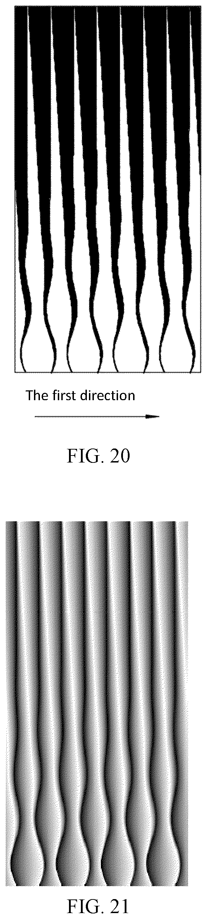

Please refer to Figure 20. Figure 20 is another structural schematic diagram of the decorative substrate provided in Embodiment 3 of the present application. Figure 20 is based on Figure 19, adding the vertex trend line of each convex portion, and the area on the right side of the line is filled with dark color to improve image recognition. It can be seen from Figure 20 that the vertex trend line of the convex portion is not parallel to the second direction, and the vertex trend of the convex portion shows a changing trend from right to left.

Please refer to Figure 21, Figure 21 is a schematic diagram of the effect of the decorative substrate provided in Embodiment 3 of the present application.

The above-mentioned embodiment only expresses one embodiment of the present application. The description is relatively specific and detailed, but it should not be understood as limiting the patent scope of the present application. It should be noted that, for those of ordinary skill in the art, several modifications and improvements can be made without departing from the design concept of the present application, and these all fall within the protection scope of the present application. Therefore, the scope of protection of this application should be determined by the appended claims.

## Claims

1. A decorative substrate (100), **characterized in that**, the decorative substrate comprising a base material (20) and a texture layer (10) arranged on the surface of the base material, and the texture layer having a plurality of texture units (11) arranged sequentially along a first direction, each texture units including a convex portion (12), and an cross-sectional outline of the convex portion in a third direction transitioning from arc segments to straight line segments along the second direction, the second direction being perpendicular to the first direction, and the third direction being perpendicular to the first direction and the second direction; the highest point of the cross-sectional outline of the convex portion in a third direction satisfies at least one of the following relationships: a distance from the highest point of the cross-sectional outline of the convex portion in a third direction to the base material surface varies in the second direction; or the line connecting the orthographic projection of the highest point of the cross-sectional outline of the convex portion in the third direction on the base material is a curve segment or a straight line segment, and the straight line segment is not parallel to the second direction.

2. The decorative substrate of claim 1, wherein the convex portion comprises a linear segment (121) and a nonlinear segment (122) in the second direction, and the outer contour of the orthographic projection on the base material of the linear segment is a straight line, and the outer contour of the orthographic projection of the nonlinear segment on the base material is an arc shape.

3. The decorative substrate according to claim 2, wherein an outer contour of the orthographic projection of the nonlinear segment on the base material is wavy.

4. The decorative substrate according to claim 2, wherein the nonlinear segment includes a wide portion and a narrow portion; a maximum width of any of the wide portions is greater than a maximum width of the linear segment, or a minimum width of any of the narrow portions is less than a minimum width of the linear portion.

5. The decorative substrate according to claim 1, wherein a distance from the highest point of the cross-sectional outline of the convex portion in a third direction to the base material surface changes linearly in the second direction.

6. The decorative substrate according to claim 1, wherein a distance from a highest point of the cross-sectional outline of the convex portion in a third direction to the base material surface changes non-linearly in the second direction.

7. The decorative substrate according to claim 1, wherein the distance between adjacent convex portions ranges from 1 µm to 200 µm.

8. The decorative substrate according to claim 1, wherein the width of the convex portion in the first direction ranges from 1 µm to 200 µm.

9. The decorative substrate according to claim 1, wherein the height difference between the highest point of the cross-sectional outline of the convex portion and the lowest point of the cross-sectional outline of the convex portion in the first direction is 0.5 µm to 20 µm.

10. The decorative substrate according to any one of claims 1 to 9, **characterized in that** the decorative substrate further comprising a modification layer, the modification layer includes at least one of a color layer, a frosted layer, and a glitter layer, and the modification layer is disposed on a surface of at least one of the texture layer or the base material.

11. A method for manufacturing a decorative substrate, **characterized in that**, the method comprising:
forming a texture layer on the surface of the base material to obtain the decorative substrate; the texture layer is formed by at least one of transfer printing, etching and hot press molding; the texture layer has a plurality of texture units arranged sequentially along first direction, each of the texture units includes a convex portion, the cross-sectional outline of the convex portion in the third direction transitions from an arc segment to a straight line segment along the second direction, and the second direction is perpendicular to the a first direction, the third direction is perpendicular to the first direction and the second direction;
the highest point of the cross-sectional outline of the convex portion in a third direction satisfies at least one of the following relationships: the distance from the highest point of the cross-sectional outline of the convex portion in a third direction to the base material surface changes in the second direction; or the line connecting the orthographic projection of the highest point of the cross-sectional outline of the convex portion in the third direction on the base material is a curve segment or a straight line segment, and the straight line segment is not parallel to the second direction.

12. A cover plate (300), **characterized in that**, the cover plate comprising the decorative substrate (100) according to any one of claims 1-10 and a base body (101), the decorative substrate is disposed on the surface of the base body.

13. An electronic device (200), **characterized in that**, the electronic device comprising a display component (201) and a housing (202) that cooperates with the display component, wherein the housing includes the cover plate (300) according to claim 12.
